# EUROPÄISCHE PATENTANMELDUNG

(11) **EP 4 726 942 A1**
(43) Veröffentlichungstag der Anmeldung: **15.04.2026**
(21) Anmeldenummer: 25204201.5
(22) Anmeldetag: 24.09.2025
(51) Int. Cl.: H02H 3/16, G01R 31/08, H02H 3/33, G01R 31/52, H02H 7/26

(54) **RÜCKSTROMKANAL UND VERFAHREN FÜR DIE VERWENDUNG EINES FEHLERSTROM-SCHUTZGERÄTES MIT DIFFERENZSTROMSENSOR IN EINEM UNGEERDETEN DC-STROMVERSORGUNGSSYSTEM**

(30) Priorität: 11.10.2024 DE 102024129448
(71) Anmelder: Bender GmbH & Co. KG, 35305 Grünberg (DE)
(72) Erfinder: Reitz, Julian, 35305 Grünberg (DE); Schepp, Karl, 35447 Reiskirchen (DE)
(74) Vertreter: advotec.

(57) **Zusammenfassung**

Die Erfindung betrifft einen Rückstromkanal (20) sowie ein Verfahren für die Verwendung eines Fehlerstrom-Schutzgerätes (4) mit Differenzstromsensor (8) in einem ungeerdeten DC-Stromversorgungssystem (2), in welchem der Rückstromkanal (20) zum Einsatz gelangt. Der Rückstromkanal (20) besteht aus einer elektronischen Schaltung (22), die zweipolig jeweils zwischen einen der aktiven Leiter (DC+, DC-) des ungeerdeten DC-Stromversorgungssystems (2) und Erde (PE) angekoppelt ist und dafür ausgelegt ist, bei kurzzeitig intermittierendem Auftreten eines niederohmigen Isolationsfehlers (1) automatisch temporär aktiviert zu werden, um einen Fehlerstromkreis auszubilden, in dem ein strombegrenzter Fehlerstrom (I_{f}) fließt, der das Fehlerstrom-Schutzgerät (4) auslöst.

## Beschreibung

Die Erfindung betrifft einen Rückstromkanal und ein Verfahren für die Verwendung eines Fehlerstrom-Schutzgerätes mit Differenzstromsensor (Messstromwandler) in einem ungeerdeten DC-Stromversorgungssystem mit aktiven Leitern.

Das ungeerdete DC-Stromversorgungssystem sowie das in dem ungeerdeten DC-Stromversorgungssystem installierte Fehlerstrom-Schutzgerät stellen eine voraussetzungsgemäße Anwendungsumgebung der Erfindung dar und sind nicht Bestandteil der Erfindung.

Bei der Versorgung von elektrischen Betriebsmitteln wird bei erhöhten Anforderungen an die Betriebs-, Brand- und Berührungssicherheit vielfach die Netzform eines ungeerdeten Stromversorgungssystems eingesetzt - auch als isoliertes Netz (IT-Netz) bezeichnet. Solche Netze sind in der Norm DIN VDE 0100-410 beschrieben. Der Vorteil dieser Netze liegt darin, dass bei einem ersten Isolationsfehler (Erdschluss oder Körperschluss) die Funktion der elektrischen Betriebsmittel nicht beeinträchtigt wird.

Für den Betrieb eines solchen Netzes ist grundsätzlich der Einsatz eines Isolationsüberwachungssystems gefordert, um bei Auftreten eines ersten Fehlers eine Alarmmeldung zu erzeugen und den Isolationsfehler möglichst schnell lokalisieren und beseitigen zu können, bevor es durch einen zweiten Fehler zu einer Abschaltung des Netzes kommt. Die Anforderungen für geeignete Isolationsüberwachungsgeräte (IMDs) sind in der internationalen Norm IEC 61557-8 festgelegt.

Zwar wird durch das Isolationsüberwachungsgerät ein Isolationsfehler erkannt, der Fehlerort aber ist in dem oftmals räumlich weit verzweigten Stromversorgungssystem jedoch noch unbekannt. Zur Lokalisierung eines fehlerhaften Leitungsabgangs startet daher nach der Erkennung des Isolationsfehlers eine (zweig-)selektive Isolationsfehlersuche. Dazu werden vorrangig Isolationsfehlersuchsysteme nach der Norm IEC 61557-9 eingesetzt, die in das Stromversorgungssystem zentral an dem Einspeisepunkt einen Prüfstrom einspeisen, dessen räumlicher Verlauf durch in dem zu überwachenden Stromversorgungssystem verteilt angeordnete Messstromwandler nachvollzogen werden kann, da sich der Prüfstrom über die (Isolations-)Fehlerstelle schließt und von allen Messstromwandlern erkannt wird, die in dem Fehler-(Prüf-)Stromkreis liegen.

Die Messzeit bzw. Reaktionszeit für die Erkennung von Isolationsfehlern in ungeerdeten Stromversorgungssystemen beträgt deutlich über 1s (z.B. 5s bis 100s), sodass z.B. sogenannte Erdschlusswischer, also kurzzeitig intermittierend auftretende, niederohmige Isolationsfehler nicht erkannt werden. In geerdeten Stromversorgungssystemen, z.B. in einem TN-Netz, kommen für die schnelle Abschaltung Fehlerstrom-Schutzgeräte zum Einsatz, die auch im Millisekunden-Bereich eine Abschaltung oder eine Fehlererkennung durchführen können. Unter Fehlerstrom-Schutzgeräten seien vorliegend als übergeordneter Begriff derartige Schutzgeräte verstanden, die zur Erkennung eines Fehlerstroms einen Differenzstromsensor aufweisen - dies sind vornehmlich Fehlerstrom-Schutzeinrichtungen (RCD), modular ausgeführte Fehlerstrom-Schutzeinrichtungen mit externer Abschalteinrichtung (MRCD) und Differenzstrom-Überwachungseinrichtungen (RCM).

Für das ungeerdete Stromversorgungssystem und insbesondere für das ungeerdete Gleichstrom-Stromversorgungssystem (DC-Stromversorgungssystem) sind solche Fehlerstrom-Schutzgeräte nur bedingt geeignet, da im ersten Fehlerfall kein ausreichend großer Fehlerstrom fließt, um eine selektive Abschaltung oder Fehlererkennung durch Differenzstrommessung zu bewerkstelligen.

Bekannt sind Verfahren, mit denen durch eine entsprechende Anpassung der Messzeiten und der Schwellwerte für bestimmte Netzbedingungen eine Überwachung möglich ist, sofern in dem IT-Netz ausreichend große Netzableitkapazitäten vorhanden sind. Teilweise werden auch künstliche Netzableitkapazitäten eingefügt, um als Rückstromkanal für den Fehlerstrom zu dienen und somit das Fehlerstrom-Schutzgerät für eine Abschaltung oder Alarmmeldung auszulösen. Diese Methode funktioniert jedoch nur zuverlässig in einem ungeerdeten Wechselstromnetz (AC-IT-Netz), im ungeerdeten Gleichspannungsnetz (DC-IT-Netz) hingegen nicht. Außerdem ist eine künstliche Erhöhung der Netzableitkapazität kontraproduktiv zu den Vorteilen eines IT-Systems hinsichtlich des Brand-, Personen- und Anlagenschutzes und beeinträchtigt die Funktionsweise der geforderten Isolationsüberwachungsgeräte.

Aus der Offenlegungsschrift DE 10 2021 114 260 A1 ist eine elektrische Schaltungsanordnung zur normgerechten Isolationsüberwachung mit Schnellabschaltung bei Erdschlusserkennung für ein ungeerdetes Stromnetz bekannt. Dabei ist ein IMD am Sternpunkt eines ungeerdeten Stromversorgungssystems angekoppelt und in dem Ankoppelzweig wird mit einem allstromsensitiven Differenzstromsensor (Messstromwandler) ein Fehlerstrom erfasst. Dieser wird in einer Auswerteeinrichtung bewertet, um im Fehlerfall das Stromversorgungssystems mittels einer separaten Schaltvorrichtung abschalten zu können.

Die Offenlegungsschrift DE 10 2021 127 848 A1 zeigt ein Verfahren und eine Vorrichtung zur Erkennung und Lokalisierung von zyklischen Kurzzeit-Isolationsfehlern in einem ungeerdeten Stromversorgungssystem. Dazu werden diverse Prozessgrößen, welche beispielsweise Aktivitäten von Maschinen erkennen lassen, mit einem mittels Differenzstromsensor gemessenen Differenzstrom korreliert.

Die bislang bekannten Lösungen sind jedoch nur unter bestimmten technischen Voraussetzungen anwendbar - es müssen beispielsweise hinreichend große Netzableitkapazitäten vorhanden sein oder ein AC-IT-Netz vorliegen - und berücksichtigen nicht die Verwendung von handelsüblichen Fehlerstrom-Schutzgeräten wie RCDs, MRCDs oder RCMs.

Der Erfindung liegt somit die Aufgabe zugrunde, in einem ungeerdeten DC-Stromversorgungssystem kurzzeitig intermittierend auftretende, niederohmige Isolationsfehler erkennen zu können und somit die Verwendung handelsüblicher Fehlerstrom-Schutzgeräte - die wegen nicht hinreichend großem Fehlerstrom sonst nicht auslösen würden - zur selektiven Abschaltung von Leitungsabgängen zu ermöglichen.

Diese Aufgabe wird bezogen auf eine Vorrichtung gelöst durch einen Rückstromkanal bestehend aus einer elektronischen Schaltung, die zweipolig jeweils zwischen einen der aktiven Leiter und Erde angekoppelt ist und dafür ausgelegt ist, bei kurzzeitig intermittierendem Auftreten eines niederohmigen Isolationsfehlers automatisch temporär aktiviert zu werden, um einen Fehlerstromkreis auszubilden, in dem ein strombegrenzter Fehlerstrom fließt, der das Fehlerstrom-Schutzgerät auslöst

Der zugrundeliegende Erfindungsgedanke besteht darin, bei kurzzeitig intermittierendem Auftreten des Isolationsfehlers für ein kurzes, aber ausreichend langes Zeitintervall automatisch einen Rückstromkanal bereitzustellen und so einen Fehlerstromkreis auszubilden, in dem ein begrenzter, aber hinreichend großer Fehlerstrom fließen kann, der als Differenzstrom von dem Differenzstromsensor des Fehlerstrom-Schutzgerätes detektiert wird und zu dessen Auslösung führt. Als Auslösung wird vorliegend in Abhängigkeit der Art des Fehlerstrom-Schutzgerätes (RCD, MRCD, RCM) sowohl das Auslösen einer Alarmmeldung als auch die Ausführung einer schaltenden Funktion verstanden.

Der strombegrenzte Rückstromkanal ermöglicht somit den Einsatz von handelsüblichen - gewöhnlich zur Installation in TN-Netzen vorgesehene - Fehlerstrom-Schutzgeräten in IT-Netzen zur selektiven Erdschlusswischererkennung verbunden mit einer selektiven Abschaltung des von dem Isolationsfehler betroffenen Leitungsabgangs. Zugleich werden die vorteilhaften Eigenschaften des ungeerdeten IT-Netzes nicht dauerhaft beeinträchtigt.

Der Rückstromkanal ist durch eine elektronische Schaltung realisiert, die zweipolig jeweils zwischen einen der aktiven Leiter und Erde angekoppelt ist. Die elektronische Schaltung erkennt einen kurzzeitig intermittierend auftretenden, niederohmigen Isolationsfehler und stellt daraufhin zwischen dem jeweiligen aktiven Leiter und Erde einen rein elektronisch aktivierbaren Rückstromkanal bereit, um den Fehlerstromkreis zu schließen.

Die erfindungsgemäße, schaltungstechnisch einfach ausgeführte und damit robuste elektronische Schaltung - die elektronische Schaltung weist beispielsweise keinen Mikrocontroller auf - bildet für ein kurzes Zeitintervall einen sicheren, strombegrenzten Rückstromkanal.

In weiterer Ausgestaltung weist die elektronische Schaltung einen zwischen den jeweiligen aktiven Leiter und Erde verlaufenden Ankopplungszweig mit einem Begrenzungswiderstand und einem in Reihe zu dem Begrenzungswiderstand geschalteten Schalttransistor auf, der über ein Triggersignal von einer Verriegelungslogik angesteuert wird, wobei die Verriegelungslogik Detektionssignale von adaptiven Filtern empfängt, die jeweils an den aktiven Leitern gegen Erde eine Verlagerungsspannung erfassen und bewerten.

Im Falle eines Erdschlusswischers kommt es zwischen den aktiven Leitern und Erdpotential kurzeitig zu einer sehr deutlichen Veränderung der Verlagerungsspannung mit einem charakteristischen Spannungsverlauf.

Adaptive Filter erkennen anlagenspezifisch die durch den Erdschlusswischer generierten typischen Spannungsverlagerungen bzw. deren charakteristische Spannungsverläufe und leiten diese Detektion für jeden aktiven Leiter individuell mittels Detektionssignalen weiter an die Verriegelungslogik zur wechselseitigen Verriegelung der komplementären Schalttransistoren. Wird einer der Schalttransistoren durchgeschaltet, so wird die Weiterleitung möglicher Triggersignale zur Steuerung des jeweils komplementären Schalttransistors durch die Verriegelungslogik unterbunden.

Die Schalttransistoren bilden jeweils den zwischen den aktiven Leitern und Erde verlaufenden Ankopplungszweig, über den nun ein hinreichend großer Fehlerstrom geführt wird. Begrenzungswiderstände in dem jeweiligen Ankopplungszweig stellen die für das ungeerdete DC-Stromversorgungssystem im Rahmen der Vorgaben geforderte Strombegrenzung sicher.

Vorhandene zusätzlichen Schutzgeräte wie Leitungsschutzschalter und Isolationsüberwachungsgerät werden durch diese zusätzliche elektronische Schaltung in ihrer Funktion nicht beeinträchtigt.

Der erfindungsgemäße Rückstromkanal setzt die in dem unabhängigen Verfahrensanspruch beschriebenen Verfahrensschritte um. Insoweit spiegeln sich die vorgenannten technischen Wirkungen auch in den verfahrenstechnischen Vorteilen des beanspruchten, erfindungsgemäßen Verfahrens für die Verwendung eines Fehlerstrom-Schutzgerätes mit Differenzstromsensor in einem ungeerdeten DC-Stromversorgungssystem wider.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
**Fig. 1****:** ein ungeerdetes DC-Stromversorgungssystem,
**Fig. 2****:** das ungeerdete DC-Stromversorgungssystem mit Leitungsabgängen und erfindungsgemäßem Rückstromkanal,
**Fig. 3****:** das ungeerdete DC-Stromversorgungssystem mit erfindungsgemäßem Rückstromkanal und Abschalteinrichtungen,
**Fig. 4****:** eine erfindungsgemäße elektronische Schaltung als Rückstromkanal,
**Fig. 5****:** einen zeitlichen Ablauf im Fehlerfall mit erfindungsgemä-ßem Aktivieren des Rückstromkanals und Auslösen des Fehlerstrom-Schutzgerätes und
**Fig. 6****:** das ungeerdete DC-Stromversorgungssystem mit erfindungsgemäß aktiviertem Rückstromkanal im Fehlerfall.

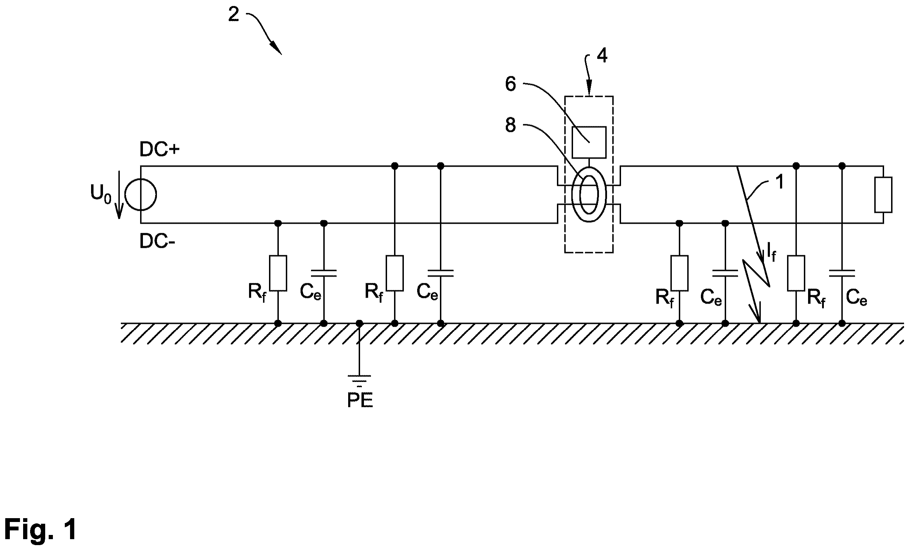

**Fig. 1** zeigt zur Erläuterung der Problemstellung ein ungeerdetes DC-Stromversorgungssystem 2 mit aktiven Leitern DC+ und DC- und einer Spannungsquelle U₀. Zwischen den aktiven Leitern DC+ und DC- weist das ungeerdete DC-Stromversorgungssystem 2 gegenüber Erde PE (Erdpotenzial) unvermeidliche Ableitimpedanzen auf, die als Isolationswiderstände R_{f} und Ableitkapazitäten Cₑ in Erscheinung treten. Zur Fehlerstrom-Überwachung ist ein beispielhaft als RCM oder MRCD ausgeführtes Fehlerstrom-Schutzgerät 4 voraussetzungsgemäß installiert, welches eine Differenzstrom-Auswerteeinheit 6 und einen Differenzstromsensor 8 aufweist.

Im Fall eines Isolationsfehlers 1 in Form eines Körper- oder Erdschlusses kann nicht - wie in geerdeten Netzen - ein Kurzschlussstrom fließen, sondern es wird sich aufgrund eines fehlenden (widerstandsfreien) Rückschlusses ein Fehlerstrom I_{f} ergeben, dessen Größe durch die Isolationswiderstände R_{f} und Ableitkapazitäten Cₑ bestimmt ist. In dem hier zugrundeliegenden ungeerdeten DC-Stromversorgungssystem 2 (Gleichstrom-Netz) erweisen sich die Ableitkapazitäten Cₑ hinsichtlich ihres elektrischen Leitwertes allerdings als unwirksam. Die Isolationswiderstände R_{f} lassen aufgrund ihres im fehlerfreien Fall sehr großen Widerstandswertes nur einen sehr geringen Fehlerstrom zu. Dieser Fehlerstrom I_{f} aber reicht nicht aus, um das Fehlerstrom-Schutzgerät 4 auszulösen.

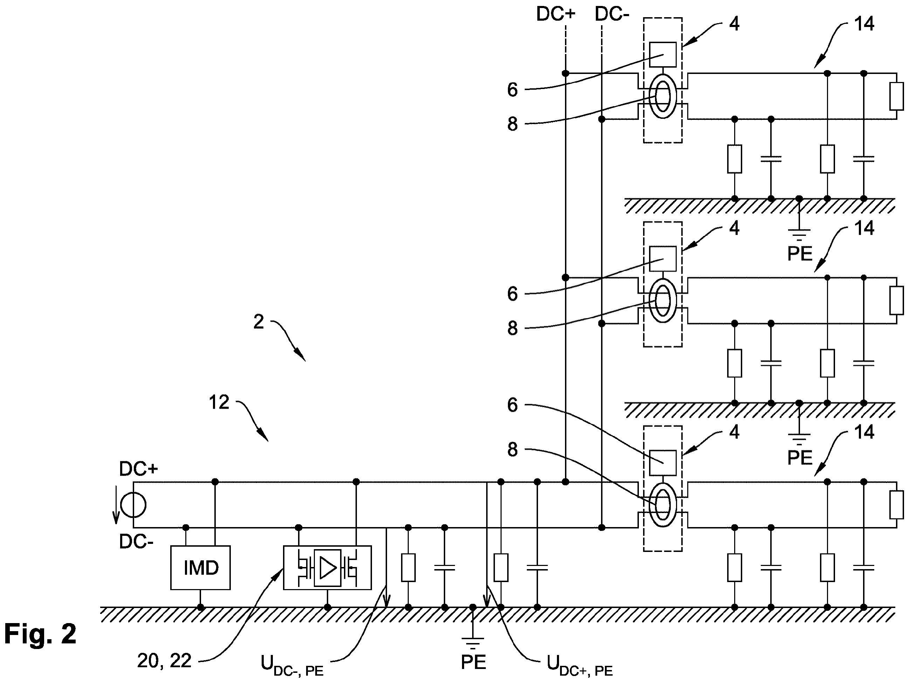

In **Fig. 2** ist das ungeerdete DC-Stromversorgungssystem 2 bestehend aus einem Hauptsystem 12 und daran angebundenen Leitungsabgängen 14 dargestellt. Die Leitungsabgänge 14 werden im Hinblick auf einen Fehlerstrom-Erkennung jeweils von dem Fehlerstrom-Schutzgerät 4 durch Differenzstrommessung (Differenzstromsensor 8) überwacht.

Ein erfindungsgemäßer Rückstromkanal 20 in Form der elektronischen Schaltung 22 ist in dem Hauptsystem 12 zweipolig jeweils zwischen einen der aktiven Leiter DC+, DC- und Erde PE angekoppelt.

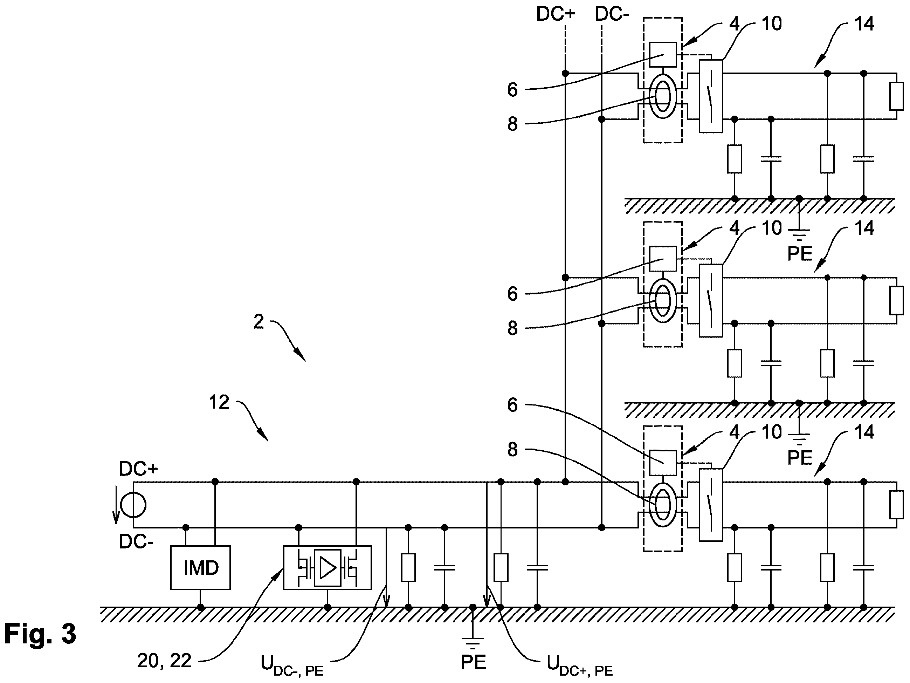

In **Fig. 3** weist das als RCM oder MRCD ausgeführte Fehlerstrom-Schutzgerät 4 jeweils eine externe Abschalteinrichtung 10 auf, die direkt an die Differenzstrom-Auswerteeinheit 6 des RCMs 4 oder MRCDs 4 angebunden ist und als externer Leistungsschalter eine zweigselektive Abschaltung eines fehlerbehafteten Leitungsabgangs 14 bewirken kann. Damit wird eine selektive Schnellauslösung ermöglicht. Alternativ kann die schaltende Funktion in Form einer Fehlerstrom-Schutzeinrichtung (RCD) in das Fehlerstrom-Schutzgerät 4 integriert sein.

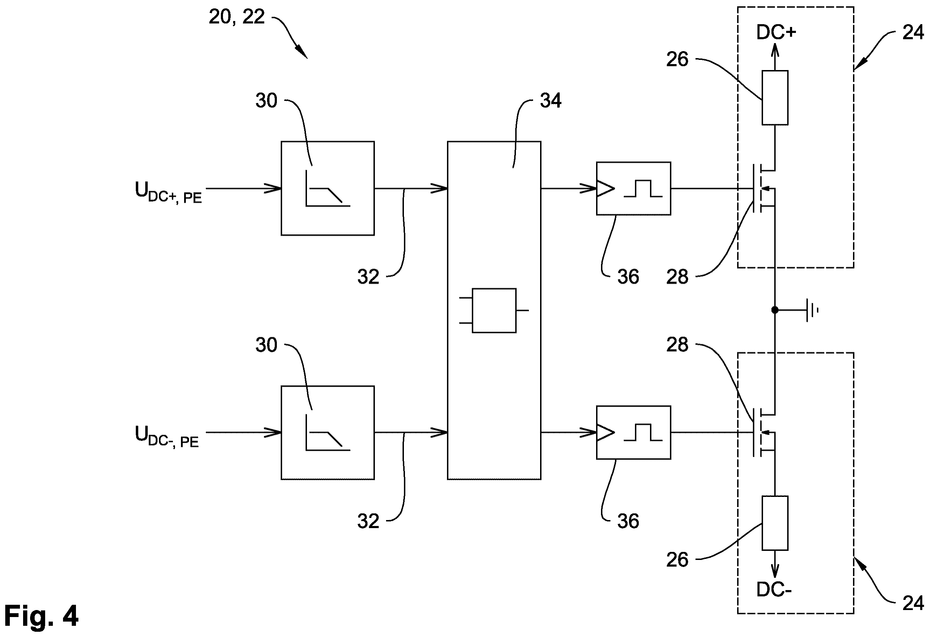

**Fig. 4** zeigt eine erfindungsgemäße elektronische Schaltung 22 in Funktion als Rückstromkanal 20 für den Fehlerstrom I_{f} (Fig. 1).

Die elektronische Schaltung 22 hat die Aufgabe, den Verlauf der Verlagerungsspannungen U_{DC+,PE}, U_{DC-,PE} zwischen den aktiven Leitern DC+, DC- und Erde PE zu erfassen, den erfassten Verlauf zu bewerten und daraus notwendige Schalthandlungen für die Schalttransistoren 28 abzuleiten.

Eine notwendige Handlungsanweisung der elektronische Schaltung 22 kann beispielweise wie folgt beschrieben werden:
Erfassen, mittels adaptiver Filter 30, der jeweiligen Verlagerungsspannung U_{DC+,PE}, U_{DC-,PE} an den aktiven Leitern DC+, DC- gegen Erde (PE) und Bewerten durch Vergleich mit Schwellwerten, beispielsweise, ob die Verlagerungsspannungen U_{DC+,PE}, U_{DC-,PE} größer als 80% der Leiter-Leiter-Spannung beträgt, oder durch Korrelation mit Spannungsmustern, ob ein für kurzzeitig intermittierend auftretende, niederohmige Isolationsfehler 8 (Fig. 1) charakteristischer Verlagerungsspannungsverlauf vorliegt.

Weiterleiten von Detektionssignalen 32 von den adaptiven Filtern 30 an eine Verriegelungslogik 34, falls eine Spannungsüberschreitung oder ein charakteristischer Verlauf einer der Verlagerungsspannungen U_{DC+,PE}, U_{DC-,PE} erkannt wird,

Ansteuern des Schalttransistors 28 des von dem Isolationsfehler 8 betroffenen aktiven Leiters DC+, DC- mittels eines Triggersignals 36 durch die Verriegelungslogik 34 für ein Zeitintervall, z. B. 50ms, welches länger als die Auslösezeit des verwendeten Fehlerstrom-Schutzgerätes 4 ist, bei gleichzeitigem

Verriegeln des jeweils komplementären Schalttransistors 28 durch die Verriegelungslogik 34.

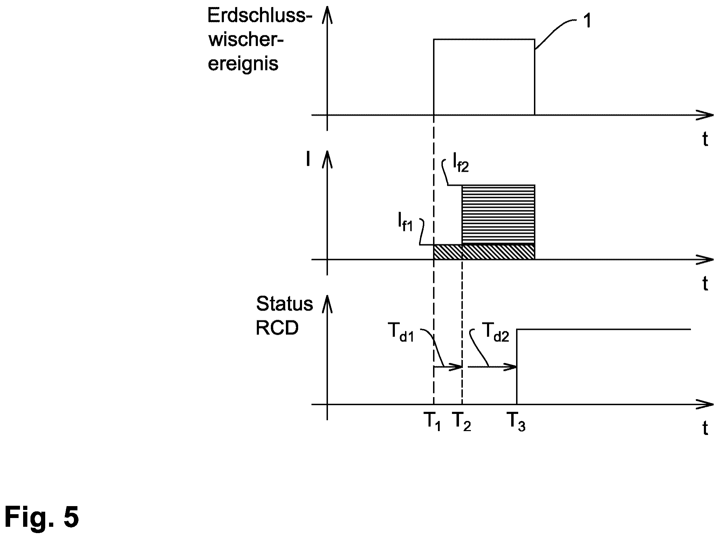

**Fig. 5** zeigt einen zeitlichen Ablauf im Fehlerfall (Erdschlusswischerereignis) mit erfindungsgemäßem Aktivieren des Rückstromkanals 20 und Auslösen des Fehlerstrom-Schutzgerätes 4.

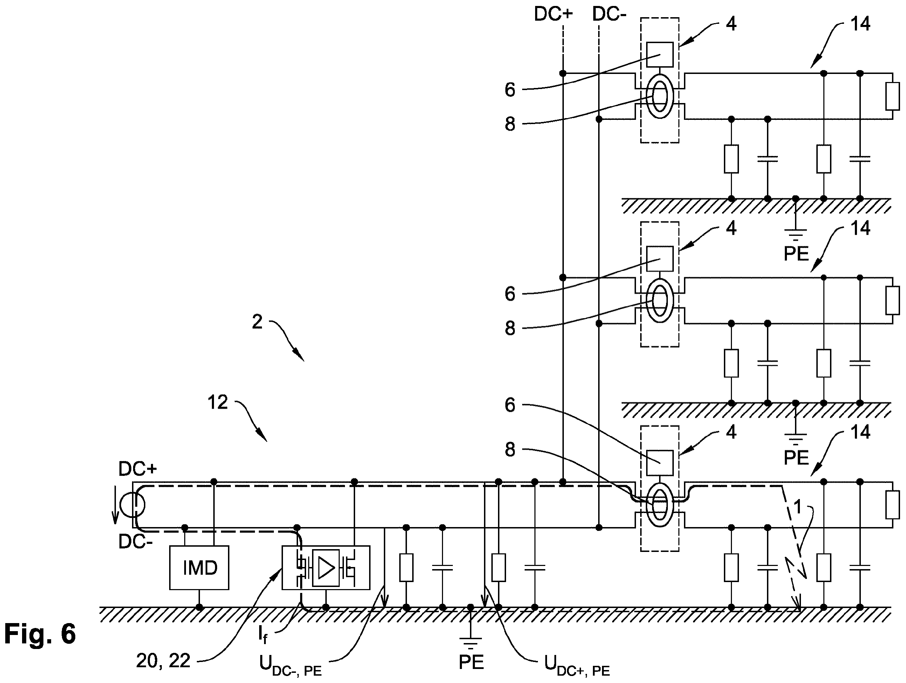

Mit dem Eintreten eines Erdschlusswischerereignisses 1 (vgl. Fig. 1 und Fig. 6) zum Zeitpunkt T₁ beginnt unmittelbar ein kleiner Fehlerstrom I_{f1} zu fließen, dessen Größe von der Ableitimpedanz R_{f}, Cₑ des Netzes bedingt und bestimmt wird. Nach einer gewissen Reaktionszeit T_{d1} von beispielsweise 1ms tritt zum Zeitpunkt T₂ ein erhöhter Fehlerstrom I_{f2} durch den Stromanteil der elektronischen Schaltung 22 auf, sodass das Fehlerstrom-Schutzgerät 4 ausgelöst werden kann. Die Auslösung erfolgt nach einer weiteren Reaktionszeit T_{d2} zum Zeitpunkt T₃.

**Fig. 6** zeigt das ungeerdete DC-Stromversorgungssystem 2 mit erfindungsgemäß aktiviertem Rückstromkanal 20 im Fehlerfall (Erdschlusswischerereignis 1).

Bei einem in dem Leitungsabgang 14 auftretendem Erdschlusswischerereignis 1 bildet sich über die als Rückstromkanal 20 wirkende elektronische Schaltung 22 ein Fehlerstromkreis aus, in dem ein zur Auslösung des Fehlerstrom-Schutzgerätes 4 hinreichend großer Fehlerstrom I_{f} fließt.

## Patentansprüche

1. Rückstromkanal (20) für die Verwendung eines Fehlerstrom-Schutzgerätes (4) mit Differenzstromsensor (8) in einem ungeerdeten DC-Stromversorgungssystem (2) mit aktiven Leitern (DC+, DC-), bestehend aus
einer elektronischen Schaltung (22), die zweipolig jeweils zwischen einen der aktiven Leiter (DC+, DC-) und Erde (PE) angekoppelt ist und dafür ausgelegt ist, bei kurzzeitig intermittierendem Auftreten eines niederohmigen Isolationsfehlers (1) automatisch temporär aktiviert zu werden, um einen Fehlerstromkreis auszubilden, in dem ein strombegrenzter Fehlerstrom (I_{f}) fließt, der das Fehlerstrom-Schutzgerät (4) auslöst

2. Rückstromkanal (20) nach Anspruch 1,
**dadurch gekennzeichnet,**
**dass** die elektronische Schaltung (22) einen zwischen die jeweiligen aktiven Leiter (DC+, DC-) und Erde verlaufenden Ankopplungszweig (24) mit einem Begrenzungswiderstand (26) und einem in Reihe zu dem Begrenzungswiderstand geschalteten Schalttransistor (28) aufweist, der über ein Triggersignal (36) von einer Verriegelungslogik (34) angesteuert wird, wobei die Verriegelungslogik (34) Detektionssignale (32) von adaptiven Filtern (30) empfängt, die jeweils an den aktiven Leitern (DC+, DC-) gegen Erde (PE) eine Verlagerungsspannung (U_{DC+,PE}, U_{DC-,PE}) erfassen und bewerten.

3. Verfahren für die Verwendung eines Fehlerstrom-Schutzgerätes (4) mit Differenzstromsensor (8) in einem ungeerdeten DC-Stromversorgungssystem (2) mit aktiven Leitern (DC+, DC-), mit automatischem temporären Aktivieren eines Rückstromkanals (20), bestehend aus einer zweipolig jeweils zwischen einen der aktiven Leiter (DC+, DC-) und Erde angekoppelten elektronischen Schaltung (22), bei kurzzeitig intermittierendem Auftreten eines niederohmigen Isolationsfehlers (1), um einen Fehlerstromkreis auszubilden, in dem ein strombegrenzter Fehlerstrom (I_{f}) fließt, der das Fehlerstrom-Schutzgerät (4) auslöst.

4. Verfahren nach Anspruch 3,
**gekennzeichnet durch**
Erfassen und Bewerten einer Verlagerungsspannung (U_{DC+,PE}, U_{DC-,PE}) jeweils an den aktiven Leitern (DC+, DC-) gegen Erde (PE) mittels adaptiver Filter (30),
Weiterleiten von Detektionssignalen (32) von den adaptiven Filtern (30) an eine Verriegelungslogik (34),
Ansteuern eines Schalttransistors (28), der in einem zwischen den jeweiligen aktiven Leiter (DC+, DC-) und Erde verlaufenden Ankopplungszweig (24) in Reihe zu einem Begrenzungswiderstand (26) angeordnet ist, mit Triggersignalen (36), und
Verriegeln des jeweils komplementären Schalttransistors (28) **durch** die Verriegelungslogik (34).
